# EUROPÄISCHE PATENTSCHRIFT

(11) **EP 4 264 689 B1**
(45) Veröffentlichungstag und Bekanntmachung des Hinweises auf die Patenterteilung: **25.02.2026**
(21) Anmeldenummer: 21840909.2
(22) Anmeldetag: 17.12.2021
(51) Int. Cl.: H10N 30/057, H10N 30/87, H10N 30/88, H10N 30/50, H10N 30/857

(54) **WANDLERELEMENT BASIEREND AUF DIELEKTRISCHEN ELASTOMEREN, VERFAHREN ZUR HERSTELLUNG EINES WANDLERELEMENTS, SOWIE HYBRIDER GREIFER**
TRANSDUCER ELEMENT BASED ON DIELECTRIC ELASTOMERS, METHOD FOR PRODUCING A TRANSDUCER ELEMENT, AND HYBRID GRIPPER
ÉLÉMENT CONVERTISSEUR À BASE D'ÉLASTOMÈRES DIÉLECTRIQUES, PROCÉDÉ DE FABRICATION D'UN ÉLÉMENT CONVERTISSEUR, AINSI QUE GRIFFE HYBRIDE

(30) Priorität: 21.12.2020 DE 102020216411
(43) Veröffentlichungstag der Anmeldung: 25.10.2023
(73) Patentinhaber: Fraunhofer-Gesellschaft zur Förderung der angewandten Forschung e.V., 80686 München (DE)
(72) Erfinder: RIESS, Sebastian, 64289 Darmstadt (DE); NOACK, Tim, 64289 Darmstadt (DE); KAAL, William, 64289 Darmstadt (DE)
(74) Vertreter: Pfenning, Meinig & Partner mbB
(86) Internationale Anmeldenummer: PCT/EP2021/086661
(87) Internationale Veröffentlichungsnummer: WO 2022/136194

(56) Entgegenhaltungen:
- EP-A1- 3 187 972
- EP-B1- 2 630 674
- WO-A2-2017/043896
- US-A1- 2003 125 781

## Beschreibung

Die Erfindung betrifft ein Wandlerelement basierend auf dielektrischen Elastomeren. Des Weiteren wird ein Verfahren zur Herstellung eines solchen Wandlerelements beschrieben, sowie ein in diesem Verfahren verwendeter hybrider Greifer.

Dielektrische Elastomere sind Materialsysteme aus der Gruppe der elektroaktiven Polymere, die sich unter Einfluss einer elektrischen Stimulation verformen. Ein dielektrisches Elastomer-Wandlerelement (DE-Wandlerelement), das elektrische Energie in mechanische Arbeit oder auch mechanische Arbeit in elektrische Energie umwandelt, also sowohl als Aktor als auch als Generator oder als Sensor wirken kann, ist dabei im Grunde wie ein elektrostatischer Kondensator aufgebaut: ein flexibler, aber inkompressibler Elastomerfilm wird zwischen zwei Elektroden angeordnet. Wird eine Spannung an die Elektroden angelegt, so ziehen sich diese elektrostatisch an, und der Elastomerfilm wird reversibel verformt. Der Elastomerfilm wird zusammengedrückt und dehnt sich in seitlicher Richtung aus. Umgekehrt lässt sich ein solches Element aus Elektroden und Elastomerfolie auch als Druck- bzw. Kraft- oder Wegsensor verwenden, da sich durch eine Veränderung des Abstands der zwei Elektroden und der damit verbundenen Verformung des Elastomers auch die Kapazität des Kondensators verändert.

Eine Form eines solchen Wandlers ist ein Stapel-Aktor, in dem mehrere planare Aktoren aus Elektroden und Elastomer aufgeschichtet sind, um bei Anlegen einer Spannung höhere Stellwege zu erreichen. Solche Wandler sind im Stand der Technik bekannt. Die Patentschrift EP 2 630 674 B1 schlägt beispielsweise ein DE-Wandlerelement mit Ausnehmungen in den metallischen Elektroden vor, durch die sich die seitliche Ausdehnung des Elastomers bei Kompression des Elements gering halten lässt, was zu einem verbesserten Betriebsverhalten bei höheren Schwingungsfrequenzen führt. Allerdings lassen sich solche Wandlerelemente bisher nicht in einfacher Weise großserientechnisch herstellen, da sich die Schichtdicken der Elektroden und Elastomerfolien üblicherweise im µm-Bereich bewegen und teilweise Hunderte dieser Schichten präzise gestapelt werden müssen, was schwer zu automatisieren ist. Eine weitere relevante Patentschrift ist die EP 3 187 972 B1.

Eine Aufgabe der vorliegenden Schutzrechtsanmeldung ist es daher, einen Aufbau eines Wandlerelements basierend auf dielektrischen Elastomeren, der sich industriell in einfacher Weise umsetzen lässt, sowie ein Verfahren zur Herstellung eines solchen Wandlerelements vorzuschlagen. Außerdem wird der Aufbau eines hybriden Greifers beschrieben, der zur Ausführung des Verfahrens geeignet ist.

Diese Aufgabe wird durch ein Wandlerelement gemäß dem unabhängigen Anspruch 1 gelöst. Ein Verfahren zur Herstellung eines solchen Wandlerelements wird in Anspruch 10 und ein hybrider Greifer zur Verwendung in diesem Verfahren in Anspruch 14 beschrieben. Weitere Ausführungsformen ergeben sich aus den abhängigen Ansprüchen.

Ein Wandlerelement basierend auf dielektrischen Elastomeren umfasst eine Trägerplatine, wobei die Trägerplatine erste Kontaktflächen, die mit einem ersten Anschlusskontakt leitend verbunden sind, und zweite Kontaktflächen, die mit einem zweiten Anschlusskontakt leitend verbunden sind, aufweist,
mindestens eine Elastomerfolie, bestehend aus einem dielektrischen Material,
mindestens zwei Elektroden, wobei die Elektroden zumindest teilweise luftdurchlässig gestaltet sind und jeweils mindestens eine Kontaktfläche zur leitenden Verbindung mit den ersten oder zweiten Kontaktflächen der Trägerplatine aufweisen,
wobei die mindestens zwei Elektroden und die mindestens eine Elastomerfolie so zwischen auf der Trägerplatine angeordnet sind, dass sich ein Stapel ergibt, in dem die Elektroden und Elastomerfolien im Wechsel angeordnet sind, und die Elektroden alternierend mit den ersten Kontaktflächen und den zweiten Kontaktflächen der Trägerplatine leitend verbunden sind, wobei die Trägerplatine eine Schirmfläche, die mit einem dritten Anschlusskontakt leitend verbunden ist, aufweist.

Die Schichten aus Elektroden und Elastomerfolien werden auf eine Trägerplatine aufgebracht, wobei die Elektroden im Wechsel mit den zwei unterschiedlichen Kontaktflächen der Trägerplatine verbunden werden, beispielsweise durch Punktschweißen. Dadurch sind die Elektroden zusammen mit den dazwischen befindlichen Elastomerfolien mechanisch fixiert und können auf einfache Weise elektrisch kontaktiert werden. Zu diesem Zweck weist die Trägerplatine Anschlusskontakte auf, die über Leiterbahnen mit den Kontaktflächen verbunden sind, so dass sich gegensätzliche Spannungen an die Elektroden anlegen lassen oder eine Sensorauswerteeinheit an die Elektroden anschließen lässt.

Werden mehr als die mindestens zwei Elektroden und mindestens eine Elastomerfolie verwendet, so werden die Kontaktflächen der Elektroden weiterhin im Wechsel mit den zwei Kontaktflächen der Trägerplatine verbunden. Eine einfache Weise, dies zu erreichen ist, die Kontaktflächen der obersten Elektrode mit den Kontaktflächen der Elektrode, die sich zwei Schichten weiter unten befindet, zu verschweißen. Zählt man die auf der Trägerplatine gestapelten Elektroden von unten von 1 bis n, wobei die erste Elektrode mit den ersten Kontaktflächen der Trägerplatine und die zweite Elektrode mit den zweiten Kontaktflächen verbunden ist, so sind die Kontaktflächen der n-ten Elektrode also jeweils mit den Kontaktflächen der (n-2)-ten Elektrode verbunden. Auf diese Weise muss nur die Trägerplatine mit einer Spannungsquelle oder Auswertungseinheit zur Messung der Kapazität verbunden werden, und ein aufwendiges Kontaktieren der einzelnen Elektroden entfällt.

In der Regel ist der Stapel aus Elektroden und Elastomerfolien so gebildet, dass jeweils eine Elastomerfolie zwischen zwei Elektroden angeordnet ist. Unter gewissen Umständen kann es jedoch auch sinnvoll sein, dass eine Elastomerfolie nur Kontakt mit einer Elektrode hat, also als erste oder letzte Schicht eines Stapels verwendet wird.

Die Anordnung des eigentlichen dielektrischen Elastomer-Wandlers als Stapel auf der Trägerplatine fixiert diesen mechanisch und sorgt für einen stabilen Stapel, wodurch eine einfachere Herstellung des Wandlerelements möglich ist. Da die Positionen der Kontaktflächen im Stapel definiert vorgegeben sind, ermöglicht dies auch ein automatisiertes Stapeln und Verschweißen der Bauteile.

Die Elastomerfolien bestehen aus Schichten mit Dicken im µm-Bereich aus Materialien wie zum Beispiel Silikonen, Acrylen oder Polyurethanen. Im Allgemeinen sollte ein als Elastomerfolie verwendetes Material eine hohe Dielektrizitätskonstante, ein niedriges Elastizitätsmodul und eine hohe Durchschlagsfestigkeit aufweisen.

Die Elektroden bestehen aus einem elektrisch gut leitenden Material und sind zumindest teilweise luftdurchlässig gestaltet. Die Elektroden haben ebenfalls Schichtdicken im µm-Bereich. Als Material bieten sich Metalle wie Kupfer, Nickel, Stahl oder Aluminium an, die im Vergleich zu dem verwendeten Elastomer ein hohes Elastizitätsmodul haben. Insbesondere in der Fläche der Elektrode, also senkrecht zu der Dicke des Wandlerelements, sind die Elektroden daher dehnstarr. Besonders vorteilhaft für das ebenfalls beschriebene Verfahren sind ferromagnetische Materialien.

Dadurch, dass die Elektroden zumindest teilweise luftdurchlässig gestaltet sind, beispielsweise durch Löcher in den Elektroden, können bei der Herstellung des Wandlerelements Vakuumgreifer zum Einsatz kommen, die einen Verbund aus einer Elektrode und einer Elastomerfolie auf einmal positionieren können, wobei sich die Elastomerfolie unter der Elektrode befindet und durch diese hindurch angesaugt werden kann. Des Weiteren kann die Luftdurchlässigkeit der Elektrode durch Ausnehmungen erreicht werden, durch die sich ein weiterer vorteilhafter Effekt ergibt. In der Anwendung des Wandlerelements bei einer Krafteinwirkung in Dickenrichtung können die Elastomerfolien in diese Ausnehmungen eindringen, so dass das gesamte Wandlerelement in Dickenrichtung komprimiert wird, die Ausdehnung des Elastomers zu den Seiten hin jedoch beschränkt wird. Auf diese Weise wird das Elastomer in seiner Ausdehnung durch die dehnstarren Elektroden weniger stark eingeschränkt.

Eine solche Strukturierung der Elektroden kann beispielsweise durch Ausnehmungen in Form von Mulden gegeben sein. Diese sind vorzugsweise auf mindestens einer der Elastomerfolie zugewandten Seite der Elektrode ausgebildet, so dass sich diese unter Druck in die Mulden hinein ausdehnen kann.

In einer weiteren Ausführung sind die Elektroden perforiert gestaltet. Dadurch ergeben sich eine Luftdurchlässigkeit und der bereits beschriebene positive Effekt des zusätzlichen Ausdehnungsraums für die Elastomerfolien. Eine Perforation der Elektroden kann dabei auch mit anderen Strukturierungen der Elektroden kombiniert werden.

Die Trägerplatine dient nicht nur zur mechanischen Fixierung und Kontaktierung des Stapels aus dielektrischen Elastomeren und Elektroden, sondern bildet erfindungsgemäß auch eine Schirmfläche zur Schirmung des Wandlerelements nach unten. Zu diesem Zweck besitzt die Trägerplatine einen dritten Anschlusskontakt, der mit der Schirmfläche verbunden ist.

Eine Schirmplatine kann den Abschluss des Stapels nach oben bilden. Auch diese Platine dient zur Abschirmung des Wandlerelements und kann daher ebenso mit der Trägerplatine verbunden werden. Durch die Schirmung des Wandlerelements wird dieses nicht durch äußere Störeinflüsse beeinträchtigt, und bei einer Verwendung als Sensor kann die Genauigkeit der Kapazitätsmessung erhöht werden.

Die Trägerplatine kann so ausgeführt sein, dass sie einen vierten Anschlusskontakt aufweist, und die Schirmplatine so, dass sie einen Anschlusskontakt aufweist, der mit der Trägerplatine verbunden werden kann, so dass die Kontaktierung der Schirmplatine ebenfalls über die Trägerplatine erfolgt. Auf diese Weise ist die komplette elektrische Kontaktierung des Wandlerelements über die Trägerplatine möglich.

Träger- und Schirmplatine können eine quadratische oder annähernd quadratische Grundform aufweisen. Bei einer solchen viereckigen Grundform können zwei gegenüberliegende Ecken der Trägerplatine die ersten Kontaktflächen bilden, während die zwei anderen gegenüberliegenden Ecken die zweiten Kontaktflächen bilden. Auf diese Weise sind die Kontaktflächen räumlich gut getrennt und leicht zu kontaktieren beziehungsweise mit weiteren Kontaktflächen zu verschweißen. Durch die Verwendung von je zwei Kontaktflächen ist außerdem eine gewisse Redundanz bei der Verbindung mit den Elektroden gegeben.

Die Form der Träger- und Schirmplatinen ist nicht auf Quadrate oder auch nur auf Vierecke beschränkt. Stattdessen können die Bauteile eine Grundfläche von beliebiger geometrischer Form aufweisen. Auch in diesem Fall sollten die Kontaktflächen jedoch räumlich so voneinander getrennt angelegt sein, dass sich Kontaktflächen von Elektroden einfach und ohne Probleme der elektrischen Leitung mit ihnen verbinden lassen. Durch die Wahl der Form einer Grundfläche der Trägerplatine wird die Bauform des Wandlerelements bestimmt und lässt sich so an verschiedene Verwendungszwecke anpassen.

Die Elektroden können ebenfalls räumlich getrennte Kontaktflächen aufweisen. Bei der Verwendung von quadratischen Träger- und Schirmplatinen bieten sich zum Beispiel auch quadratische Elektroden an, deren Kontaktflächen an zwei gegenüberliegenden Ecken der Elektroden angeordnet sind. Beim Stapeln der Elektroden und Elastomerfolien lassen sich so gestaltete Elektroden einfach um 90° drehen, um zwischen Kontakt mit den ersten Kontaktflächen und Kontakt mit den zweiten Kontaktflächen der Trägerplatine zu wechseln. Dadurch dass die Elektroden zwei räumlich getrennte Kontaktflächen aufweisen können, kann wiederum in Verbindung mit den räumlich getrennten Kontaktflächen der Trägerplatine eine gewisse Redundanz in der Spannungsversorgung/Verbindung der Elektroden mit einer Auswertungseinrichtung gewährleistet werden. Die Kontaktflächen können beispielsweise als Zungen ausgeführt sein. Bei hohen Stapeln mit vielen Schichten aus Elektroden und Elastomerfolien sind auch Ausführungen der Kontaktflächen als Zungen, die durch Verformungen Höhenunterschiede ausgleichen können, denkbar.

Eine Ausführung der Träger- und Schirmplatinen als flexible Leiterplatten ist möglich. Dadurch ergeben sich Möglichkeiten zur Anwendung des Wandlerelements auf gekrümmten Oberflächen.

Die Trägerplatine kann außerdem segmentiert sein. Auf diese Weise können auf einer Trägerplatine zum Beispiel mehrere Sensorelemente konfiguriert werden, so dass ganze Sensorarrays auf einer Platine aufgebaut werden können. Zu diesem Zweck sind weitere Kontakte an der Trägerplatine notwendig.

Ebenfalls ist es möglich, dass die Trägerplatine, insbesondere in den Bereichen um den Stapel aus Elektroden und Elastomeren, aber auch auf ihrer Unterseite, dazu ausgelegt ist, elektronische Bauteile aufzunehmen. Es kann sich dabei um Bauteile zur Auswertung der Kapazität des Wandlerelements, aber auch um Bauteile zur Ansteuerung des Elements als Aktor handeln.

Ein Verfahren zur Herstellung eines beschriebenen Wandlerelements umfasst die folgenden Schritte:
- Positionieren der Trägerplatine auf einer zum Punktschweißen geeigneten Gegenelektrode,
- Aufnehmen einer ersten Elektrode mit einem hybriden Greifer, wobei der hybride Greifer einen Elektromagneten aufweist,
- Positionieren der ersten Elektrode über der Trägerplatine,
- Punktschweißen der ersten Kontaktflächen der Trägerplatine mit den Kontaktflächen der ersten Elektrode,
- Aufnehmen einer Elastomerfolie mit dem hybriden Greifer, wobei der hybride Greifer mit einem Vakuumanschluss ausgeführt ist, so dass die Elastomerfolie angesaugt werden kann,
- Positionieren der Elastomerfolie über der ersten Elektrode,
- Aufnehmen einer zweiten Elektrode mit dem hybriden Greifer,
- Positionieren der zweiten Elektrode über der Elastomerfolie,
- Punktschweißen der zweiten Kontaktflächen der Trägerplatine mit den Kontaktflächen der zweiten Elektrode.

Durch diese Prozessschritte lässt sich mit einem geeigneten hybriden Greifer die Herstellung eines Wandlerelements auch für industrielle Anwendungen automatisieren. Durch eine automatische Positionierung ergibt sich eine hinreichend hohe Präzision, um auch dünne Schichten aufzubringen. Durch das Verschweißen der Kontaktflächen entstehen zuverlässige leitende Verbindungen.

Durch das Aufnehmen einer Schirmplatine mit dem hybriden Greifer und das Auflegen dieser auf die zweite Elektrode kann das Wandlerelement nach oben abgeschlossen werden, sodass sich ein abgeschirmtes Wandlerelement ergibt.

Da die Elektroden zumindest teilweise luftdurchlässig gestaltet sind, kann ein mit Elektromagnet und Vakuumanschluss ausgestatteter hybrider Greifer eine Elektrode und eine Elastomerfolie gleichzeitig aufnehmen, indem er die Folie über den Vakuumanschluss durch die magnetisch aufgenommene Elektrode hindurch ansaugt. Dies hat den Vorteil, dass sich die Schritte, in denen eine Elastomerfolie und eine zweite Elektrode aufgenommen und platziert werden, zusammenfassen lassen. Ein weiterer Vorteil ist, dass die Elastomerfolie bereits vor der Aufnahme durch den hybriden Greifer relativ zur Elektrode positioniert werden und durch das Vakuum fixiert werden kann. Dadurch wird der Aufbau eines Stapels vereinfacht, und es können Fehler vermieden werden.

Die Verfahrensschritte der Aufnahme und Positionierung der Elastomerfolien und der Aufnahme, Positionierung und des Verschweißens der Elektroden, insbesondere der gleichzeitigen Aufnahme, Positionierung und Verschweißung von Elastomerfolie und Elektroden, können beliebig oft wiederholt werden, um Wandlerelemente mit einer beliebigen Anzahl von Schichten zu produzieren. Die Kontaktflächen der neu hinzugefügten, n-ten Elektroden werden dabei jeweils mit denen der (n-2)-ten Elektrode verschweißt. Bei einer geeigneten Wahl der Form des Wandlerelements müssen die neu zu einem Stapel hinzugefügten Elektroden immer auf den gleichen Positionen platziert werden und zur Herstellung der verschiedenen Kontaktwege lediglich gedreht werden. Dabei bleiben die Positionen der notwendigen Punktschweißungen ebenfalls gleich, so dass kein zusätzlicher Aufwand für die Automatisierung entsteht.

In einem besonders einfachen Fall besitzen sowohl die Träger- und Schirmplatinen als auch die Elektroden quadratische Grundformen mit zusammengehörenden Kontaktflächen an gegenüberliegende Ecken des Quadrats. In diesem Fall wird jede zweite Elektrode um 90° verdreht verschweißt, um eine leitende Verbindung der ersten Kontaktflächen der Trägerplatine mit der ersten, dritten und jeder weiteren ungeraden Elektroden herzustellen, während die zweiten Kontaktflächen mit der zweiten, vierten und jeder geraden Elektrode verbunden wird.

Ein für die Ausführung dieses Verfahrens geeigneter hybrider Greifer umfasst
- einen Elektromagneten zum Aufnehmen der Elektroden,
- einen Vakuumanschluss zum Aufnehmen der Trägerplatine, der Schirmplatine und der Elastomerfolie durch die zumindest teilweise luftdurchlässige Elektrode und
- eine oder mehrere Punktschweißelektroden zum Verschweißen der Kontaktflächen.

Weiterhin kann ein solcher hybrider Greifer eine umlaufende Klinge umfassen, die dazu ausgelegt ist, eine Elastomerfolie aus einem Folien-Endlosband auszustanzen. Diese Klinge kann beheizbar ausgeführt sein. Die ausgestanzte Elastomerfolie wird daraufhin per Vakuum fixiert und ist somit automatisch korrekt am Greifer positioniert. Eine solche Zuführung der Folie ist weniger komplex als die Bereitstellung bereits ausgestanzter Folien. Besonders günstig ist es, wenn das Ausstanzen der Elastomerfolie bei bereits aufgenommener Elektrode erfolgen kann. Des Weiteren ist es auch möglich, dass die Elektroden auf eine ähnliche Weise ausgestanzt werden, oder auch sowohl Elektroden, als auch Elastomerfolien.

Ein hybrider Greifer, der zur Ausführung des Verfahrens zu Herstellung eines Wandlerelements geeignet ist, kann an einer geeigneten Verfahrkinematik oder einem Pick-and-Place-Roboter befestigt sein und über diese bewegt werden, um die Verfahrensschritte effektiv auszuführen. Somit ist eine vollständige Automatisierung des Verfahrens möglich.

Die beschriebenen Ausführungsformen der Gegenstände der vorliegenden Anmeldung können dabei sowohl einzeln verwendet als auch kombiniert werden, um zusätzliche Effekte zu erzielen und so ein einfach herzustellendes Wandlerelement auf Basis von dielektrischen Elastomeren, ein Verfahren zur Herstellung eines solchen sowie einen für dieses Verfahren verwendeten hybriden Greifer zu bieten.

Die erwähnten sowie weitere Aspekte der Erfindung werden ersichtlich anhand der detaillierten Beschreibung der Ausführungsbeispiele, die mit Hilfe der folgenden Zeichnungen gegeben wird, von welchen:
Fig. 1a eine perspektivische schematische Ansicht eines Wandlerelements ist,
Fig. 1b eine schematische Seitenansicht des Wandlerelements ist,
Fig. 2a eine schematische Darstellung einer Trägerplatine zeigt,
Fig. 2b eine schematische Darstellung einer Elektrode zeigt,
Fig. 2c eine schematische Darstellung einer Schirmplatine zeigt,
Fig. 2d eine weitere schematische Darstellung einer Elektrode zeigt,
Fig. 3 den Ablauf des Verfahrens zu Herstellung eines Wandlerelements darstellt,
Fig. 4 eine Explosionsdarstellung eines hybriden Greifers in Verwendung in dem Verfahren ist und
Fig. 5 zwei Schnittdarstellungen des hybriden Greifers zeigt.

Im Folgenden sollen die beanspruchten Gegenstände auf Basis der begleitenden Zeichnungen näher erläutert werden. Dabei beziehen sich gleiche Bezugszeichen auf gleiche Elemente.

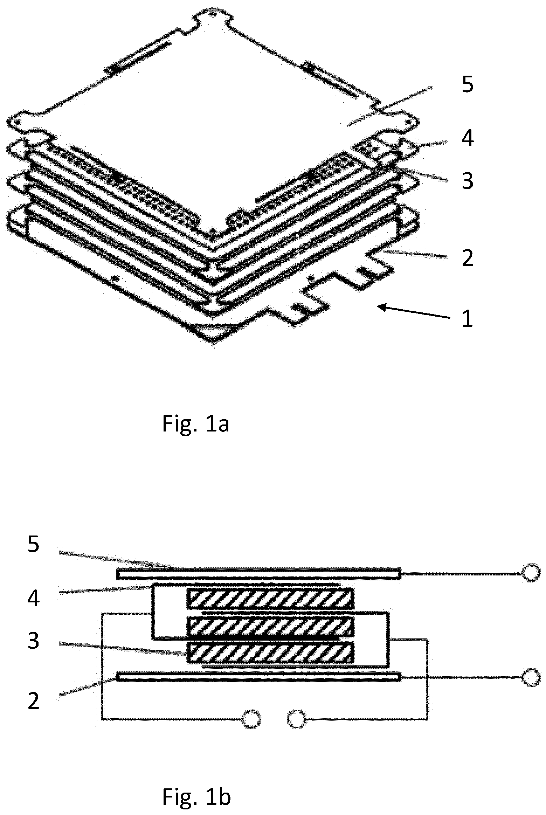

In Fig. 1a ist der Aufbau eines Wandlerelements 1 gezeigt. Es besteht aus einer Trägerplatine 2, einer Schirmplatine 5 und einem zwischen diesen angeordneten Stapel aus Elektroden 4 und Elastomerfolien 3. Im konkret gezeigten Fall besteht der Stapel aus fünf Elektroden und vier Schichten Elastomerfolien.

Es handelt sich um ein Wandlerelement mit einer annähernd quadratischen Grundform. Gut zu erkennen sind die Kontaktflächen der Elektroden. Diese sind wechselseitig angeordnet, da jede Elektrode um 90° verdreht zu der unter ihr liegenden angeordnet ist. Die Anschlusskontakte der Trägerplatine sind ebenfalls zu erkennen.

In Fig. 1b ist eine schematische Seitenansicht eines Wandlerelements gezeigt. An dieser Darstellung lässt sich die Wirkungsweise eines Wandlerelements erkennen. Im Unterschied zu Fig. 1a besteht das Wandlerelement 1 in Fig. 1b aus vier Elektroden 4 und drei zwischen diesen angeordneten Elastomerfolien 3. Fig. 1b zeigt außerdem, wie die Elektroden 4 jeweils im Wechsel mit einer Spannungsquelle verbunden sind. Durch das Anlegen einer Spannung an die Elektroden 4 wirkt eine elektrostatische Druckkraft auf diese. Die Elektroden 4 ziehen sich gegenseitig an, die Elastomerfolie 3 werden zusammengedrückt, und der gesamte Stapel verringert so seine vertikale Ausdehnung. Ebenso kann das Wandlerelement durch äußere Kräfte vertikal komprimiert werden. Die Abstände zwischen den Elektroden verändern sich, und die Elastomerfolien werden zusammengedrückt. Dadurch verändert sich die Kapazität des Wandlerelements, die durch eine Auswertungseinheit gemessen werden kann. Auf diese Weise kann das Wandlerelement als Druck-, Kraft- oder Wegsensor genutzt werden. Die Trägerplatine 2 und die Schirmplatine 5 können ebenfalls leitend miteinander und beispielsweise mit einer Erdung verbunden sein, um das Wandlerelement nach außen abzuschirmen und die Genauigkeit einer Kapazitätsmessung bei einer Verwendung des Wandlerelements 1 als Sensor zu erhöhen.

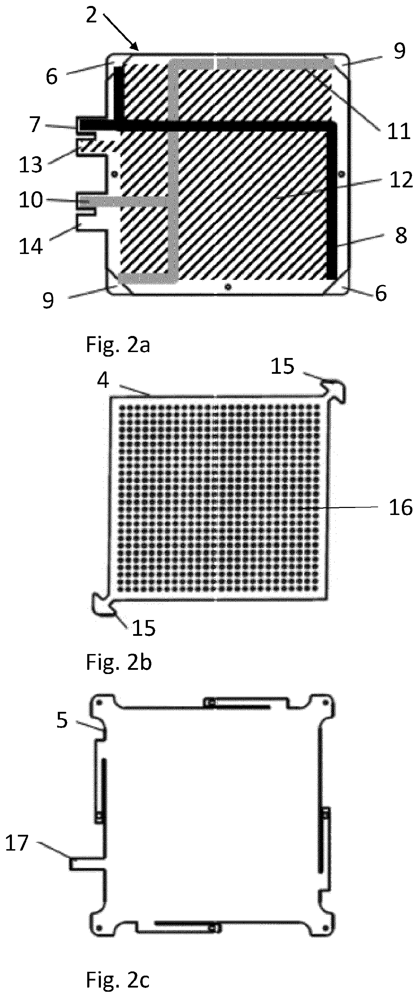

In Fig. 2a, Fig. 2b und Fig. 2c sind die einzelnen Bauteile des Wandlerelements in größerem Detail dargestellt. Fig. 2a zeigt eine mögliche Ausführung einer Trägerplatine 2 mit quadratischer Grundfläche. Diese verfügt über vier Kontaktflächen an ihren Ecken, wobei die an gegenüberliegenden Ecken angeordneten Kontaktflächen 6, 9 jeweils zusammen erste Kontaktflächen 6 zur Verbindung mit einer ersten Elektrode und zweite Kontaktflächen 9 zur Verbindung mit einer zweiten Elektrode bilden. Die ersten Kontaktflächen 6 sind über eine Leiterbahn 8 mit einem ersten Anschlusskontakt 7 verbunden, der am Rand der Trägerplatine 2 angeordnet ist. Die zweiten Kontaktflächen 9 sind über eine Leiterbahn 11 mit einem zweiten Anschlusskontakt 10 verbunden, der am Rand der Trägerplatine 2 angeordnet ist. Der Großteil der Trägerplatine 2 wird von einer Schirmfläche 12 eingenommen, die mit einem dritten Anschlusskontakt 13 verbunden ist. Der vierte Anschlusskontakt 14 dient zur Verbindung der Trägerplatine 2 mit einer Schirmplatine 5.

Die Trägerplatine, wie sie in Fig. 2a dargestellt ist, kann eine herkömmliche Leiterplatte sein, es kann sich jedoch auch um eine flexible Leiterplatte handeln. Durch die Verwendung einer flexiblen Leiterplatte ergibt sich beispielsweise die Möglichkeit, das Wandlerelement auf gekrümmten Oberflächen anzubringen. Fig. 2a zeigt eine der einfachsten Ausführungsformen der Trägerplatine. Diese kann auch so ausgeführt sein, dass sie weitere elektronische Bauteile aufnehmen kann. Dazu kann sie auch beidseitig bedruckt sein. Zusätzliche elektronische Bauteile, die auf der Trägerplatine aufgebracht werden können, sind insbesondere Bauteile zur Ansteuerung der Elektroden im aktorischen Betrieb oder Bauteile, die die Kapazität des Wandlerelements auswerten und so einen sensorischen Betrieb ermöglichen. Werden diese Bauteile direkt auf der Trägerplatine verbaut, so kann das Wandlerelement und seine Verbindung mit der Umgebung sehr platzsparend gestaltet werden.

Eine weitere Möglichkeit ist eine Segmentierung der Trägerplatine 2, bei der eine Leiterplatte in mehrere Segmente, die jeweils wie in Fig. 2a aufgebaut sind, aufgeteilt wird. Auf diese Weise lassen sich zum Beispiel mehrere Sensorelemente auf einer Platine anordnen, was einen einfachen Aufbau von Sensorarrays ermöglicht.

Fig. 2b zeigt eine mögliche Ausführung einer Elektrode 4. Die Elektrode 4 besteht aus einem elektrisch leitfähigen Material, vorzugsweise einer Metallschicht. Sie hat ebenfalls eine quadratische Grundfläche, bei der die Kontaktflächen 15 als überstehende, pfeilförmige Zungen in zwei gegenüberliegenden Ecken ausgebildet sind. Dies ermöglicht ein einfaches Verschweißen der Kontaktflächen 15 mit den ersten Kontaktflächen 6 oder, wenn die Elektrode um 90° gedreht wird, mit den zweiten Kontaktflächen 9 der Trägerplatine 2. So können die Elektroden 4 mit geringem Arbeitsaufwand auf der Trägerplatine 2 gestapelt und mit dieser leitend verbunden werden. Bei höheren Stapeln können auch längere Zungen oder Zungen, die dazu konfiguriert sind, Höhenunterschiede auszugleichen, vorteilhaft sein.

Die Elektrode 4 weist eine Perforierung 16 auf. Diese dient zum einen dazu, den zwischen den Elektroden 4 angeordneten Elastomerfolien 3 einen Raum zu geben, in den sie sich bei einer vertikalen Kompression ausdehnen können. Dadurch kann die flächige Ausdehnung der Elastomerfolien 3 verringert werden, und die Elektroden müssen nicht dehnbar gestaltet werden, um die entstehende größere Fläche der Elastomerfolien 3 abzudecken, was eine Herstellung der Elektroden aus dehnstarren, metallischen Materialien ermöglicht. Durch die Vermeidung der Flächenausdehnung verbessert sich auch das Ansprech- bzw. Betriebsverhalten des Wandlerelements in bestimmten Frequenzbereichen, da ein geringerer Leistungsverlust durch die Verformung der Randbereiche der Elastomerfolien 3 auftritt. Zum anderen ist die Perforierung 16 auch für die Herstellung eines Wandlerelements 1 nützlich, da sie die Elektrode zumindest teilweise luftdurchlässig macht und so erlaubt, eine Elastomerfolie 3 und eine Elektrode 4 gleichzeitig mit einem Vakuumgreifer aufzunehmen. Die Elastomerfolie 3 wird dabei durch die Elektrode 4 hindurch angesaugt. Dies ermöglicht es, Elastomerfolie 3 und Elektrode 4 bereits vor der Aufnahme durch einen Greifer zueinander auszurichten und als Einheit auf einem Stapel eines Wandlerelements 1 zu platzieren. Eine aufwendige präzise Positionierung der einzelnen Bauteile auf dem Stapel entfällt. Dieses Verfahren und ein für dieses Verfahren geeigneter hybrider Greifer werden in späteren Abschnitten genauer beschrieben.

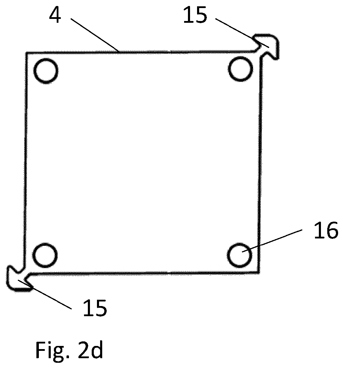

In Fig. 2d ist eine alternative Ausführung der Elektrode 4 gezeigt. Bei dieser wird die Luftdurchlässigkeit durch eine Perforierung 16 in Form von großen Löchern in den Ecken der Elektrode 4 erreicht. Bei dieser Ausführung ist der Effekt der Löcher als Ausdehnungsraum für die Elastomerfolie 3 eingeschränkt, allerdings kann dies durch zusätzliche Strukturierung der Elektrode ausgeglichen werden.

Eine einfache Schirmplatine 5 ist in Fig. 2c dargestellt. Diese dient dazu, das Wandlerelement nach oben abzuschirmen. Zu diesem Zweck dient die Schirmplatine 5 als Schirmfläche, die über einen Anschlusskontakt 17 mit dem vierten Anschlusskontakt 14 der Trägerplatine verbunden werden kann. Auch bei der Schirmplatine 5 kann es sich um eine flexible Leiterplatte handeln. Durch die Verwendung einer flexiblen Leiterplatte ergibt sich beispielsweise die Möglichkeit, das Wandlerelement auf gekrümmten Oberflächen anzubringen. Die in Fig. 2c zusätzlich erkennbaren Zungen und Bohrungen (ebenso zu sehen in Fig. 2a) dienen zur mechanischen Fixierung der Schirmplatine gegen die Trägerplatine. Die Zungen sind daher dazu ausgelegt, Höhenunterschiede kompensieren zu können, um auch Wandlerelemente mit vielschichtigen, hohen Stapeln aus Elektroden und Elastomerfolien zu ermöglichen.

In Fig. 2a/b/c/d sind die Bauteile eines Wandlerelements mit einer einfachen quadratischen Grundform gezeigt. Die Trägerplatine 2, die Elektroden 4 und die Schirmplatine 5 könne jedoch auch beliebige andere Geometrien annehmen, um speziellen Gegebenheiten oder Ansprüchen angepasst werden zu können.

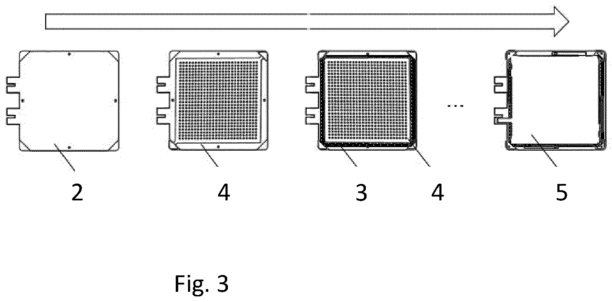

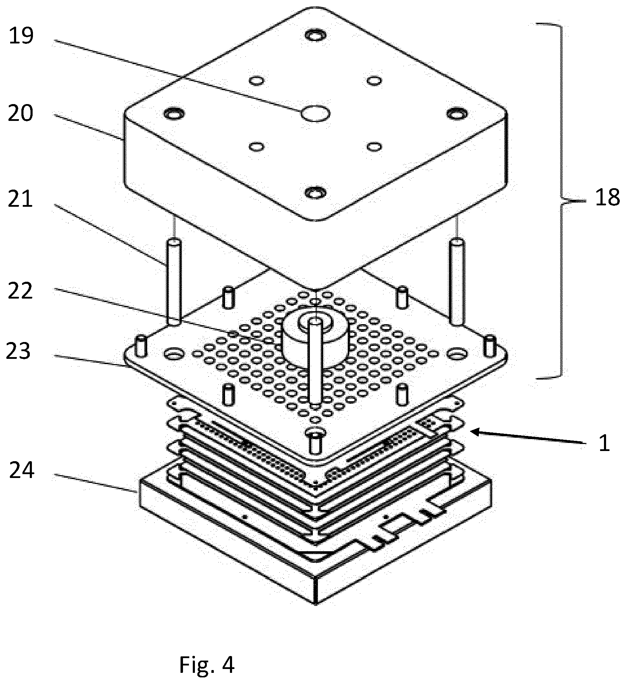

Fig. 3 stellt den Ablauf eines Verfahrens zur Herstellung eines Wandlerelements dar. Der Pfeil zeigt den zeitlichen Verlauf der einzelnen Verfahrensschritte an. In einem ersten Schritt wird eine Trägerplatine 2 auf einer zum Punktschweißen geeigneten Gegenelektrode 24 (in Fig. 4 zu sehen) positioniert.

Auf dieser Trägerplatine 2 wird in einem zweiten Schritt eine erste Elektrode 4 positioniert. Dazu wird die Elektrode 4 mit dem Elektromagneten 22 eines hybriden Greifers 18 aufgenommen. Die Kontaktflächen dieser ersten Elektrode werden daraufhin mit den ersten Kontaktflächen 6 der Trägerplatine 2 verschweißt.

In einem dritten Schritt wird eine Elastomerfolie 3 aufgenommen. Dazu ist ein hybrider Greifer 18 mit einem Vakuumanschluss 19 besonders geeignet. Die Elastomerfolie wird auf der ersten Elektrode 4 platziert. Eine zweite Elektrode 4 wird aufgenommen und um 90° zur ersten Elektrode 4 gedreht auf der Elastomerfolie 3 platziert. Durch einen geeigneten hybriden Greifer 18 können diese Teilschritte in einem einzigen Verfahrensschritt ausgeführt werden. Dazu wird die zweite Elektrode 4 durch einen Elektromagneten 22 aufgenommen und gleichzeitig die Elastomerfolie 3 durch die Perforation der Elektrode 4 hindurch angesaugt. Beide Schichten können so auf einmal auf der ersten Elektrode 4 positioniert werden. So muss die Position der Elastomerfolie 3 bei der Positionierung der zweiten Elektrode 4 nicht überprüft werden, und eine mögliche Verschiebung der Elastomerfolie 3 zwischen ihrer Aufbringung und der Fixierung durch die zweite Elektrode 4 kann verhindert werden. Die Elastomerfolie 3 kann zu diesem Zweck relativ zur zweiten Elektrode 4 positioniert werden, bevor beide zusammen durch den hybriden Greifer 18 aufgenommen werden. Nachdem Elastomerfolie 3 und zweite Elektrode 4 auf dem Stapel platziert wurden, werden die Kontaktflächen 15 der zweiten Elektrode 4 mit den zweiten Kontaktflächen 9 der Trägerplatine verschweißt.

Das Aufnehmen und Aufbringen einer Schicht aus Elastomerfolie 3 und zweiter Elektrode 4, insbesondere das Aufnehmen und Aufbringen von Elastomerfolie 3 und zweiter Elektrode 4 gleichzeitig, kann nun beliebig oft wiederholt werden, bis eine gewünschte Stapelhöhe erreicht ist. Dabei wird jede neu hinzugefügte Elektrode 4 um 90° zur vorhergehenden Elektrode 4 gedreht aufgebracht und jeweils mit der unter der vorhergehenden liegenden Elektrode 4 verschweißt. So wird erreicht, dass alle Elektroden in ungeradzahligen Schichten des Stapels mit dem ersten Anschlusskontakt 7 der Trägerplatine 2 und alle Elektroden in geradzahligen Schichten des Stapels mit dem zweiten Anschlusskontakt 10 der Trägerplatine 2 leitend verbunden sind.

In einem letzten Schritt wird die Schirmplatine 5 auf den Stapel aufgebracht und der Schirmkontakt 17 mit dem vierten Anschlusskontakt 14 der Trägerplatine verbunden.

Das beschriebene Verfahren hat mehrere Vorteile gegenüber einem herkömmlichen Verfahren, bei dem die Schichten von Hand gestapelt und miteinander verschraubt werden. Mit einem geeigneten hybriden Greifer 18 lässt es sich zum einen automatisiert ausführen. Der Greifer kann dabei auch sehr dünne Schichten präzise handhaben und diese reproduzierbar positionieren. Wenn Elastomerfolie 3 und Elektrode 4 gemeinsam von dem hybriden Greifer 18 aufgenommen werden, erübrigt sich ein Ausrichten der beiden Bauteile zueinander auf dem Stapel, wodurch eine weitere Fehlerquelle beseitigt wird.

Das in diesem Verfahren verwendete Punktschweißen hat gegenüber herkömmlich verwendeten Verschraubungen den Vorteil, weniger Raum in Anspruch zu nehmen und ohne zusätzliche komplexe Bauteile eine verlässlich leitfähige Verbindung zwischen den Elektroden 4 und der Anschlüssen 7 und 10 der Trägerplatine 2 herzustellen.

Ein zur Ausführung des beschriebenen Verfahrens geeigneter hybrider Greifer 18 ist in Fig. 4 dargestellt. Dabei ist der hybride Greifer 18 auf den Aufbau eines Wandlerelements wie in Fig. 1 und Fig. 2 abgestimmt. Für andere Geometrien des Wandlerelements wären ebenso angepasste Geometrien des hybriden Greifers 18 notwendig. Der hybride Greifer 18 besteht aus einem Gehäuse 20 mit einem Vakuumanschluss 19, einem Elektromagneten 22 und einem Gitter 23. In den vier Ecken des Gehäuses 20 sind PunktschweißElektroden 21 angebracht, deren Positionen auf die Positionen der Kontaktflächen 6, 9 und 15 der Trägerplatine 2 und der Elektroden 4 abgestimmt sind. In Fig. 4 ist der hybride Greifer 18 in Benutzung gezeigt, die Darstellung zeigt außerdem das Wandlerelement 1 und eine zum Punktschweißen geeignete Gegenelektrode 24.

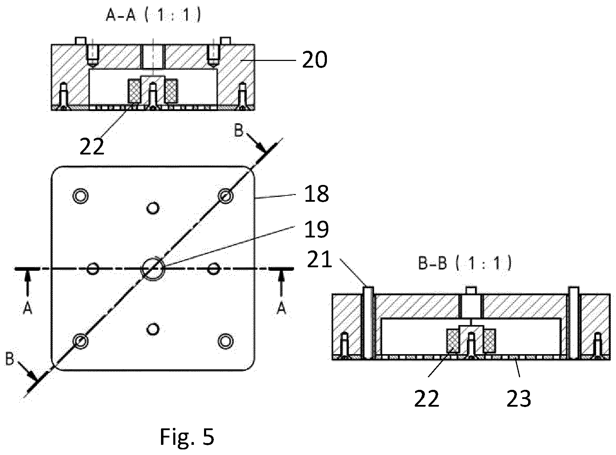

Fig. 5 zeigt zwei Schnitte durch den hybriden Greifer 18. Im Schnitt A-A ist zu sehen, dass das Gehäuse 20 hohl ausgeführt ist, so dass über den zentralen Vakuumanschluss 19 ein Unterdruck innerhalb des Greifers 18 erzeugt werden kann. Durch das Gitter 22 können so Komponenten wie eine Elastomerfolie 3 angesaugt und fixiert werden. Gleichzeitig ermöglicht der Elektromagnet 22 das Aufnehmen von ferromagnetischen Bauteilen, wie der metallischen Elektrode 4. Der Schnitt entlang der Achse B-B umfasst außerdem die an gegenüberliegenden Ecken angeordneten Punktschweißelektroden, die dazu dienen, die Elektroden 4 mit dauerhaften Verbindungen zu fixieren.

Der hybride Greifer 18 kann außerdem mit einer umlaufenden Klinge ausgestattet sein. Diese kann beheizbar ausgeführt sein. Mit einer umlaufenden Klinge können Elastomerfolien 3 direkt aus einem Folien-Endlosband ausgestanzt werden und durch den hybriden Greifer 18 aufgenommen werden. Besonders bei dünnen Schichtdicken der Elastomerfolien 3 kann dies sinnvoll sein, da das vorherige Ausstanzen und Bereitstellen als Stapel von Elastomerfolien in diesen Fällen fehleranfällig ist. Ein komplexer Positioniervorgang des Greifers zur Aufnahme der Elastomerfolie 3 entfällt dabei ebenfalls. Ist die umlaufende Klinge so ausgeführt, dass der hybride Greifer 18 bei bereits aufgenommener Elektrode 4 eine Elastomerfolie 3 ausstanzen kann, so kann diese korrekt positioniert ausgestanzt und fixiert werden, so dass Elastomerfolie 3 und Elektrode 4 gemeinsam auf den Stapel aufgebracht werden können.

Um eine Automatisierung des Verfahrens zu Herstellung eines Wandlerelements zu ermöglichen, sollte der hybride Greifer 18 so ausgeführt sein, dass er über eine geeignete Verfahrkinematik mit hinreichender Präzision bewegt werden kann. Dazu bietet sich beispielsweise ein Pick-and-Place-Roboter an, der die verschiedenen Positionen zur Aufnahme von Elektroden, Elastomerfolien, Träger- und Schirmplatine sowie die Position einer Gegenelektrode zum Punktschweißen anfahren kann.

Um das Verfahren zu automatisieren, ist also eine Ausführung besonders geeignet, in der der hybride Greifer 18 über eine Verfahrkinematik drei Positionen anfahren kann, an denen er jeweils Trägerplatinen 2, Elektroden 4 und Schirmplatinen 5 mit dem Elektromagneten 22 aufnehmen kann. An einer vierten Position wird ihm eine Endlosfolie zugeführt, aus der er eine Elastomerfolie 3 ausstanzt und über ein Vakuum fixiert. Alle Bauteile werden an einer fünften Position auf einer Gegenelektrode 24 gestapelt und verschweißt.

Die hier gezeigten Ausführungsbeispiele sind nicht begrenzend. Insbesondere können die Merkmale dieser Ausführungsbeispiele miteinander kombiniert werden, um zusätzliche Effekte zu erzielen. Für den Fachmann ist offensichtlich, dass Änderungen an diesen Ausführungsbeispielen vorgenommen werden können, ohne die grundlegenden Prinzipien des Gegenstandes dieser Schutzanmeldung zu verlassen, deren Bereich in den Ansprüchen definiert ist.

## Patentansprüche

1. Wandlerelement (1) basierend auf dielektrischen Elastomeren, umfassend
eine Trägerplatine (2), wobei die Trägerplatine erste Kontaktflächen (6), die mit einem ersten Anschlusskontakt (7) leitend verbunden sind, und zweite Kontaktflächen (9), die mit einem zweiten Anschlusskontakt (10) leitend verbunden sind, aufweist,
mindestens eine Elastomerfolie (3), bestehend aus einem dielektrischen Material,
mindestens zwei Elektroden (4), wobei die Elektroden zumindest teilweise luftdurchlässig gestaltet sind und jeweils mindestens eine Kontaktfläche (15) zur leitenden Verbindung mit den ersten oder zweiten Kontaktflächen der Trägerplatine aufweisen,
wobei die mindestens zwei Elektroden (4) und die mindestens eine Elastomerfolie (3) so auf der Trägerplatine (2) angeordnet sind, dass sich ein Stapel ergibt, in dem die Elektroden (4) und Elastomerfolien (3) im Wechsel angeordnet sind, und die Elektroden (4) alternierend mit den ersten Kontaktflächen (6) und den zweiten Kontaktflächen (9) der Trägerplatine (2) leitend verbunden sind,
**dadurch gekennzeichnet, dass** die Trägerplatine (2) eine Schirmfläche (12), die mit einem dritten Anschlusskontakt (13) leitend verbunden ist, aufweist.

2. Wandlerelement (1) nach Anspruch 1, **dadurch gekennzeichnet, dass** die mindestens zwei Elektroden (4) zumindest auf einer Seite so strukturiert sind, dass sie Ausnehmungen in Form von Mulden aufweisen.

3. Wandlerelement nach einem der Ansprüche 1 oder 2, **dadurch gekennzeichnet, dass** die mindestens zwei Elektroden perforiert (16) sind.

4. Wandlerelement (1) nach einem der vorhergehenden Ansprüche,
**dadurch gekennzeichnet, dass** das Wandlerelement eine Schirmplatine (5) umfasst, die den Stapel aus mindestens zwei Elektroden (4) und mindestens einer Elastomerfolien (3) auf der von der Trägerplatine (2) abgewandten Seite abschließt.

5. Wandlerelement (1) nach Anspruch 4, **dadurch gekennzeichnet, dass** die Trägerplatine (2) einen vierten Anschlusskontakt (14) aufweist und die Schirmplatine (5) einen Schirmkontakt (17) zur Verbindung mit dem vierten Anschlusskontakt (14) aufweist.

6. Wandlerelement (1) nach einem der Ansprüche 4 oder 5, **dadurch gekennzeichnet, dass** die Trägerplatine (2) und die Schirmplatine (5) eine quadratische oder annähernd quadratische Grundform aufweisen und die Trägerplatine (2) erste Kontaktflächen (6) an zwei gegenüberliegenden Ecken der quadratischen Grundfläche und zweite Kontaktflächen (9) an den zwei anderen gegenüberliegenden Ecken der quadratischen Grundfläche aufweist.

7. Wandlerelement (1) nach einem der Ansprüche 4 oder 5, **dadurch gekennzeichnet, dass** die Trägerplatine (2) und die Schirmplatine (5) eine Grundfläche von beliebiger geometrischer Form aufweist und die ersten Kontaktflächen (6) und die zweiten Kontaktflächen (9) der Trägerplatine räumlich voneinander getrennt sind.

8. Wandlerelement (1) nach einem der vorhergehenden Ansprüche,
**dadurch gekennzeichnet, dass** die mindestens zwei Elektroden (4) jeweils zwei räumlich getrennte Kontaktflächen (15) aufweisen.

9. Wandlerelement nach einem der vorhergehenden Ansprüche, **dadurch gekennzeichnet, dass** die Trägerplatine (2) und/oder die Schirmplatine (5) als flexible Leiterplatten ausgeführt sind;
und/oder die Trägerplatine (2) segmentiert ist;
und/oder die Trägerplatine (2) dazu ausgeführt ist, elektronische Bauteile aufzunehmen.

10. Verfahren zur Herstellung eines Wandlerelement (1) nach einem der Ansprüche 1 bis 9, umfassend die folgenden Schritte:
Positionieren der Trägerplatine (2) auf einer zum Punktschweißen geeigneten Gegenelektrode (24), sodass die die Kontaktflächen (6,9) der Trägerplatine in Kontakt mit der Gegenelektrode (24) sind,
Aufnehmen einer ersten Elektrode (3) mit einem hybriden Greifer (18), wobei der hybride Greifer (18) einen Elektromagneten (22) aufweist,
Positionieren der ersten Elektrode (3) über der Trägerplatine (2),
Punktschweißen der ersten Kontaktflächen (6) der Trägerplatine (2) mit den Kontaktflächen (15) der ersten Elektrode,
Aufnehmen einer Elastomerfolie (3) mit dem hybriden Greifer (18), wobei der hybride Greifer (18) mit einem Vakuumanschluss (19) ausgeführt ist, sodass die Elastomerfolie (3) angesaugt werden kann,
Positionieren der Elastomerfolie (3) über der ersten Elektrode (4),
Aufnehmen einer zweiten Elektrode (4) mit dem hybriden Greifer (18),
Positionieren der zweiten Elektrode (4) über der Elastomerfolie (3),
Punktschweißen der zweiten Kontaktflächen (9) der Trägerplatine (2) mit den Kontaktflächen (15) der zweiten Elektrode (4).

11. Verfahren nach Anspruch 10, zusätzlich umfassend die Schritte:
Aufnehmen der Schirmplatine (5) mit einem hybriden Greifer (18), und
Auflegen der Schirmplatine (5) auf die zweite Elektrode (4).

12. Verfahren nach einem der Ansprüche 10 oder 11, **dadurch gekennzeichnet, dass** eine Elektrode (4) und eine Elastomerfolie (3) gleichzeitig durch den hybriden Greifer (18) aufgenommen und positioniert werden, wobei die Elastomerfolie (3) von dem hybriden Greifer (18) durch die Elektrode (4) hindurch angesaugt wird und/oder die Schritte des Aufnehmens und Positionierens der Elastomerfolie (3) und der zweiten Elektrode (4) so lange wiederholt werden, bis eine gewünschte Stapelhöhe erreicht ist und wobei Kontaktflächen (15) der jeweils neu hinzugefügten zweiten Elektroden (4) nicht mit den Kontaktflächen (15) der direkt darunter liegenden Elektrode (4), sondern mit denen der im Stapel unter dieser liegenden verschweißt werden.

13. Verfahren nach einem der Ansprüche 10 bis 12, **dadurch gekennzeichnet, dass** die erste Elektrode (4) und die zweite Elektrode (4) eine quadratische Grundform mit Kontaktflächen (15) an zwei gegenüberliegenden Ecken haben und im Stapel um 90° zu einander verdreht angeordnet werden.

14. Hybrider Greifer (18), der geeignet ist, ein Verfahren nach einem der Ansprüche 10 bis 13 auszuführen, umfassend
einen Elektromagneten (22) zum Aufnehmen der Elektroden (4),
einen Vakuumanschluss (19) zum Aufnehmen der Trägerplatine (2), der Schirmplatine (5) und der Elastomerfolie (3) durch die zumindest teilweise luftdurchlässige Elektrode (4) und
eine oder mehrere Punktschweißelektroden (21) zum Verschweißen der Kontaktflächen (6, 9, 15).

15. Hybrider Greifer (18) nach Anspruch 14, außerdem umfassend eine umlaufende Klinge, die dazu ausgelegt ist, die Elastomerfolie (3) aus einem Folien-Endlosband oder die Elektrode (4) auszustanzen,
und/oder die Trägerplatine (2) dazu ausgeführt ist, elektronische Bauteile aufzunehmen.

## Claims

1. A transducer element (1) based on dielectric elastomers, comprising
a carrier board (2), wherein the carrier board comprises first contact surfaces (6), which are conductively connected to a first connector contact (7), and second contact surfaces (9), which are conductively connected to a second connector contact (10),
at least one elastomer film (3), consisting of a dielectric material,
at least two electrodes (4), wherein the electrodes are at least partially air-permeable and each have at least one contact surface (15) for conductively connecting to the first or second contact surfaces of the carrier board, wherein the at least two electrodes (4) and the at least one elastomer film (3) are arranged on the carrier board (2) so that a stack is formed, in which the electrodes (4) and elastomer films (3) are arranged alternately, and the electrodes (4) are conductively connected alternately to the first contact surfaces (6) and the second contact surfaces (9) of the carrier board (2),
**characterized in that** the carrier board (2) has a shielding surface (12), which is conductively connected to a third connector contact (13).

2. The transducer element (1) according to claim 1, **characterized in that** the at least two electrodes (4) are structured on at least one side so that they have recesses in the form of troughs.

3. The transducer element according to any one of claims 1 or 2, **characterized in that** the at least two electrodes (16) are perforated.

4. The transducer element (1) according to any one of the preceding claims, **characterized in that** the transducer element comprises a shield board (5), which terminates the stack of at least two electrodes (4) and at least one elastomer film (3) on the side facing away from the carrier board (2).

5. The transducer element (1) according to claim 4, **characterized in that** the carrier board (2) has a fourth connector contact (14) and the shield board (5) has a shield contact (17) for connecting to the fourth connector contact (14).

6. The transducer element (1) according to any one of claims 4 or 5, **characterized in that** the carrier board (2) and the shield board (5) have a square or approximately square base shape and the carrier board (2) has first contact surfaces (6) on two opposite corners of the square base surface and the and second contact surfaces (9) on the two other opposite corners of the square base surface.

7. The transducer element (1) according to any one of claims 4 or 5, **characterized in that** the carrier board (2) and the shield board (5) have a base surface of any geometric shape and the first contact surfaces (6) and the second contact surfaces (9) of the carrier board are spatially separated from one another.

8. The transducer element (1) according to any one of the preceding claims, **characterized in that** the at least two electrodes (4) each have two spatially separated contact surfaces (15).

9. The transducer element according to any one of the preceding claims, **characterized in that** the carrier board (2) and/or the shield board (5) are configured as flexible circuit boards;
and/or the carrier board (2) is segmented;
and/or **in that** the carrier board (2) is configured to accommodate electronic components.

10. A method for producing a transducer element (1) according to any one of claims 1 to 9, comprising the following steps:
positioning the carrier board (2) on a counter electrode (24) suitable for spot welding, so that the contact surfaces (6, 9) of the carrier board are in contact with the counter electrode (24),
picking up a first electrode (3) with a hybrid gripper (18), wherein the hybrid gripper (18) has an electromagnet (22),
positioning the first electrode (3) over the carrier board (2),
spot welding the first contact surfaces (6) of the carrier board (2) to the contact surfaces (15) of the first electrode,
picking up an elastomer film (3) with the hybrid gripper (18), wherein the hybrid gripper (18) is configured to have a vacuum connection (19), so that the elastomer film (3) can be suctioned,
positioning the elastomer film (3) over the first electrode (4),
picking up a second electrode (4) with the hybrid gripper (18),
positioning the second electrode (4) over the elastomer film (3),
spot welding the second contact surfaces (9) of the carrier board (2) to the contact surfaces (15) of the second electrode (4).

11. A method in accordance with claim 10, additionally comprising the steps:
picking up the shield board (5) with a hybrid gripper (18), and
placing the shield board (5) on the second electrode (4).

12. The method according to any one of claims 10 or 11, **characterized in that** an electrode (4) and an elastomer film (3) are picked up and positioned at the same time by the hybrid gripper (18), wherein the elastomer film (3) is suctioned by the hybrid gripper (18) through the electrode (4),
and/or **in that** the steps of picking up and positioning the elastomer film (3) and the second electrode (4) are repeated until a desired stack height is achieved and wherein contact surfaces (15) of the newly added second electrodes (4) are not welded to the contact surfaces (15) of the directly underlying electrode (4), but to those of the one below it in the stack.

13. The method according to any one of claims 10 to 12, **characterized in that** the first electrode (4) and the second electrode (4) have a square base shape with contact surfaces (15) on two opposite corners and are arranged in the stack rotated 90° relative to one another.

14. A hybrid gripper (18), which is suitable for performing a method according to any one of claims 10 to 13, comprising
an electromagnet (22) for picking up the electrodes (4),
a vacuum connection (19) for picking up the carrier board (2), the shield board (5) and the elastomer film (3) through the at least partially air-permeable electrode (4), and
one or more spot welding electrodes (21) for welding the contact surfaces (6, 9, 15).

15. A hybrid gripper (18) according to claim 14, further comprising a rotating blade, which is configured to punch out the elastomer film (3) from a continuous film strip or the electrode (4),
and/or in that the carrier board (2) is configured to accommodate electronic components.

## Revendications

1. Élément convertisseur (1) à base d'élastomères diélectriques, comprenant
une carte porteuse (2), la carte porteuse présentant des premières surfaces de contact (6) reliées de manière conductrice à un premier contact de borne (7) et des secondes surfaces de contact (9) reliées de manière conductrice à un deuxième contact de borne (10),
au moins un film élastomère (3) constitué d'un matériau diélectrique,
au moins deux électrodes (4), les électrodes étant au moins partiellement perméables à l'air et présentant respectivement au moins une surface de contact (15) permettant une connexion conductrice avec les premières ou secondes surfaces de contact de la carte porteuse, les au moins deux électrodes (4) et le au moins un film élastomère (3) étant agencés sur la carte porteuse (2) de manière à former une pile au sein de laquelle les électrodes (4) et les films élastomères (3) sont agencés de manière alternée, et les électrodes (4) sont connectées de manière conductrice alternativement aux premières surfaces de contact (6) et aux secondes surfaces de contact (9) de la carte porteuse (2),
**caractérisé en ce que** la carte porteuse (2) présente une surface de blindage (12) qui est connectée de manière conductrice à un troisième contact de borne (13).

2. Élément convertisseur (1) selon la revendication 1, **caractérisé en ce que** les au moins deux électrodes (4) sont structurées au moins sur un côté de sorte qu'elles présentent des cavités en forme de gouttières.

3. Élément convertisseur selon l'une quelconque des revendications 1 ou 2, **caractérisé en ce que** les au moins deux électrodes sont perforées (16).

4. Élément convertisseur (1) selon l'une quelconque des revendications précédentes, **caractérisé en ce que** l'élément convertisseur comprend une carte de blindage (5) qui ferme la pile constituée d'au moins deux électrodes (4) et d'au moins un film élastomère (3) sur le côté opposé à la carte porteuse (2).

5. Élément convertisseur (1) selon la revendication 4, **caractérisé en ce que** la carte porteuse (2) présente un quatrième contact de borne (14) et la carte de blindage (5) présente un contact de blindage (17) permettant une connexion avec le quatrième contact de borne (14).

6. Élément convertisseur (1) selon l'une quelconque des revendications 4 ou 5, **caractérisé en ce que** la carte porteuse (2) et la carte de blindage (5) présentent une forme de base carrée ou approximativement carrée et la carte porteuse (2) présente des premières surfaces de contact (6) aux deux coins opposés de la surface de base carrée et des secondes surfaces de contact (9) aux deux autres coins opposés de la surface de base carrée.

7. Élément convertisseur (1) selon l'une quelconque des revendications 4 ou 5, **caractérisé en ce que** la carte porteuse (2) et la carte de blindage (5) présentent une surface de base de forme géométrique quelconque et les premières surfaces de contact (6) et les secondes surfaces de contact (9) de la carte porteuse sont spatialement séparées les unes des autres.

8. Élément convertisseur (1) selon l'une quelconque des revendications précédentes, **caractérisé en ce que** les au moins deux électrodes (4) présentent respectivement deux surfaces de contact (15) spatialement séparées.

9. Élément convertisseur selon l'une quelconque des revendications précédentes, **caractérisé en ce que** la carte porteuse (2) et/ou la carte de blindage (5) sont réalisées sous forme de cartes de circuits imprimés flexibles ;
et/ou la carte porteuse (2) est segmentée ;
et/ou la carte porteuse (2) est conçue pour accueillir des composants électroniques.

10. Procédé de fabrication d'un élément convertisseur (1) selon l'une quelconque des revendications 1 à 9, comprenant les étapes ci-dessous consistant à :
positionner la carte porteuse (2) sur une contre-électrode (24) adaptée au soudage par points, de sorte que les surfaces de contact (6,9) de la carte porteuse sont en contact avec la contre-électrode (24),
saisir une première électrode (3) avec une pince hybride (18), la pince hybride (18) présentant un électroaimant (22),
positionner la première électrode (3) au-dessus de la carte porteuse (2),
souder par points les premières surfaces de contact (6) de la carte porteuse (2) aux surfaces de contact (15) de la première électrode,
saisir un film élastomère (3) avec la pince hybride (18), la pince hybride (18) étant munie d'un raccord de vide (19) de sorte que le film élastomère (3) peut être aspiré,
positionner le film élastomère (3) au-dessus de la première électrode (4),
saisir une seconde électrode (4) avec la pince hybride (18),
positionner la seconde électrode (4) au-dessus du film élastomère (3),
souder par points les secondes surfaces de contact (9) de la carte porteuse (2) aux surfaces de contact (15) de la seconde électrode (4).

11. Procédé selon la revendication 10, comprenant en outre les étapes consistant à :
saisir la carte de blindage (5) avec une pince hybride (18), et
placer la carte de blindage (5) sur la seconde électrode (4).

12. Procédé selon l'une quelconque des revendications 10 ou 11, **caractérisé en ce qu'**une électrode (4) et un film élastomère (3) sont simultanément saisis et positionnés grâce à la pince hybride (18), le film élastomère (3) étant aspiré par la pince hybride (18) à travers l'électrode (4),
et/ou les étapes de saisie et de positionnement du
film élastomère (3) et de la seconde électrode (4) sont répétées jusqu'à ce qu'une hauteur de pile souhaitée soit atteinte, les surfaces de contact (15) de chaque seconde électrode (4) nouvellement ajoutée n'étant pas soudées aux surfaces de contact (15) de l'électrode (4) située directement en dessous, mais plutôt à celles de l'électrode située en dessous de celle-ci au sein de la pile.

13. Procédé selon l'une quelconque des revendications 10 à 12, **caractérisé en ce que** la première électrode (4) et la seconde électrode (4) ont une forme de base carrée avec des surfaces de contact (15) au niveau de deux coins opposés et sont agencées dans la pile en étant tournées de 90° l'une par rapport à l'autre.

14. Pince hybride (18) appropriée pour la mise en œuvre d'un procédé selon l'une quelconque des revendications 10 à 13, comprenant
un électroaimant (22) permettant de saisir les électrodes (4),
un raccord de vide (19) permettant de saisir la carte porteuse (2), la carte de blindage (5) et le film élastomère (3) à travers l'électrode (4) au moins partiellement perméable à l'air et
une ou plusieurs électrode(s) de soudage par points (21) permettant de souder les surfaces de contact (6, 9, 15).

15. Pince hybride (18) selon la revendication 14, comprenant en outre une lame rotative conçue pour découper le film élastomère (3) à partir d'une bande continue de film ou l'électrode (4),
et/ou la carte porteuse (2) est conçue pour accueillir des composants électroniques.
